# EUROPÄISCHE PATENTSCHRIFT

(11) **EP 1 323 183 B1**
(45) Veröffentlichungstag und Bekanntmachung des Hinweises auf die Patenterteilung: **16.12.2009**
(21) Anmeldenummer: 01982179.2
(22) Anmeldetag: 04.10.2001
(51) Int. Cl.: H01L 21/02

(54) **VERFAHREN ZUM HERSTELLEN EINES MIKROELEKTRONISCHEN SCHALTKREISES**
METHOD FOR PRODUCING A MICROELECTRONIC CIRCUIT
PROCEDE DE FABRICATION D'UN CIRCUIT MICRO-ELECTRONIQUE

(30) Priorität: 04.10.2000 DE 10048960
(43) Veröffentlichungstag der Anmeldung: 02.07.2003
(73) Patentinhaber: Infineon Technologies AG, 81669 München (DE)
(72) Erfinder: LAUTERBACH, Christl, 85635 Höhenkirchen-Siegertsbrunn (DE); PAULUS, Christian, 82362 Weilheim (DE)
(74) Vertreter: Dokter, Eric-Michael
(86) Internationale Anmeldenummer: PCT/DE2001/003792
(87) Internationale Veröffentlichungsnummer: WO 2002/029863

(56) Entgegenhaltungen:
- DE-A- 19 737 294
- US-A- 5 446 311
- US-A- 5 652 173
- US-A- 5 793 272

## Beschreibung

Ein mikroelektronischer Schaltkreis ist aus [1] bekannt. Dieser mikroelektronische Schaltkreis ist ein integriertes Halbleiterelement, das ein elektrisch leitfähiges Element (eine Induktorspule) aufweist.

Ein Problem mit solchen, aus dem Stand der Technik bekannten, elektrisch leitfähigen Elementen ist, dass die ihnen innewohnende Leitfähigkeit relativ gering ist. Dies erfordert spezielle Betriebsbedingungen, wie z.B. niedrige Temperaturen, oder führt bei festgelegten Betriebsbedingungen, z.B. bei festgelegten Temperaturen, zu einer schlechten Güte des elektrisch leitfähigen Elements. Dies führt wiederum zu einer schlechten Güte des integrierten Halbleiterelements, das das leitfähige Element aufweist.

Ferner ist in [2] eine auf einem Keramik-Substrat aufgebrachte Spule beschrieben.

[3] beschreibt ein Verfahren zum Reparieren eines Halbleiterspeichers. In einem Halbleiterchip, der Sicherungen und eine Redundanzspeicherzelle aufweist, die eine normale Speicherzelle ersetzen kann, werden in dem Fall, dass eine normale Speicherzelle fehlerhaft ist, die Sicherungen herausgeschnitten, um dadurch die Redundanzspeicherzelle anstelle der fehlerhaften normalen Speicherzelle anzuschließen.

In [4] ist ein Verfahren zum Herstellen eines induktiven Elements oder eines Kondensatorelements auf einem Halbleiterchip, wobei in einem zwischen zwei Metallschichten vorbestimmter Form parallel zur Chipebene angeordneten Dielektrikum wenigstens ein die Metallschichten durchkontaktierender Metallstopfen von der Länge der Metallschichten angeordnet wird.

[5] beschreibt ein Verfahren zum Herstellen einer monolithisch integrierten Spule in einem mikroelektronischen Schaltkreis, bei dem während des Fertigungsprozesses des mikroelektronischen Schaltkreises die Spule gebildet wird. Auf einer auf einem Substrat aufgebrachten ersten elektrisch leitenden Schicht wird eine strukturierte dielektrische Schicht aufgebracht und darauf eine zweite, strukturierte, elektrisch leitende Schicht. Durch die dielektrische Schicht hindurch werden die erste und die zweite elektrisch leitende Schicht miteinander elektrisch kontaktiert.

[6] beschreibt ein Verfahren, bei dem ein monolithischer mikroelektronischer Schaltkreis mit dicken, verlustarmen Leiterbahnen hergestellt wird. Diese Leiterbahnen sind besonders nützlich für die Herstellung von Spulen und Zusammenschaltungen.

[7] beschreibt Spiral- und Toroidalförmige Spulen mit hoher Güte und Transformatoren. Die Spiralspulen weisen einen Metallkern mit ferromagnetischen Oberschichten auf und sind nach unten mit einer Leiterbahn in einer dielektrischen Schicht kontaktiert.

Somit liegt der Erfindung das Problem zugrunde, die Güte einer monolithisch integrierten Spule in einem mikroelektronischen Schaltkreis zu verbessern. Erfindungsgemäß wird dieses Problem durch Bereitstellen eines Verfahrens zum Herstellen eines mikroelektronischen Schaltkreises mit einem verbesserten, elektrisch leitfähigen Element gelöst.

Erfindungsgemäß wird ein mikroelektronischer Schaltkreis mit einer verbesserten, monolithisch integrierten Spule durch ein Verfahren hergestellt,
- bei dem ein funktionsfähiger, fertig prozessierter mikroelektronischer Schaltkreis mit einer monolithisch integrierten Spule und mit einer oberhalb zumindest der monolithisch integrierten Spule befindlichen Passivierungsschicht bereitgestellt wird;
- bei dem ein Teil der Passivierungsschicht oberhalb der monolithisch integrierten Spule entfernt wird, so dass ein Bereich der Spule freigelegt wird; und
- bei dem oberhalb der monolithisch integrierten Spule eine Metallschicht aufgebracht wird derart, dass die Metallschicht mit der monolithisch integrierten Spule elektrisch leitend gekoppelt wird, womit eine verdickte Leiterbahn der monolithisch integrierten Spule gebildet wird, womit die Güte der monolithisch integrierten Spule erhöht wird.

Die monolithisch integrierte Spule ist aus elektrisch leitfähigem Material hergestellt.

Das erfindungsgemäße Verfahren bewirkt die Verdickung einer bereits bestehenden, elektrisch leitfähigen monolithisch integrierten Spule in einem fertig prozessierten, mikroelektronischen Schaltkreis mit einem Metall, das dieselbe oder eine höhere Leitfähigkeit wie das Metall der monolithisch integrierten Spule besitzt. Durch dieses Verdicken der monolithisch integrierten Spule wird gegenüber dem unverdickten Zustand mehr leitendes Material auf Leiterbahnen der monolithisch integrierten Spule aufgebracht, was zu einer gegenüber dem unverdickten Zustand reduzierten Impedanz führt. Mit der Herabsetzung der Impedanz geht eine entsprechende Erhöhung der Leitfähigkeit der betroffenen, monolithisch integrierten Spule des mikroelektronischen Schaltkreises einher.

Durch die Erfindung wird somit in vorteilhafter Weise eine verbesserte Güte des elektrisch leitfähigen Elements eines mikroelektronischen Schaltkreises erzielt.

Ein weiterer Vorteil des erfindungsgemäßen Verfahrens ist, dass sich das Verfahren an die Herstellung eines bereits fertig prozessierten mikroelektronischen Schaltkreises anschließt.

Unter dem Ausdruck "fertig prozessiert" ist derjenige Zustand des mikroelektronischen Schaltkreises zu verstehen, den der mikroelektronische Schaltkreis beim Gelangen in die nächsthöhere Stufe des Herstellungsmarkts hat. Im Rahmen der Erfindung ist das Produkt beispielsweise als fertig prozessiert anzusehen, wenn ein Hersteller von Computerkomponenten diesen mikroelektronischen Schaltkreis ohne die Beschaffenheit des mikroelektronischen Schaltkreises in irgendwelcher Weise zu ändern in eine Computerkomponente nur noch einzubauen hat, und der mikroelektronische Schaltkreis, und daher auch die Computerkomponente selbst, die planmäßige Funktion auszuführen imstande ist.

Im Rahmen der Erfindung ist also ein fertig prozessierter mikroelektronischer Schaltkreis ein Schaltkreis, dessen Zustand nach der herkömmlichen Herstellung derart vollendet und abgeschlossen ist, dass er normalerweise den für diesen Schaltkreis vorgesehenen Zweck, ohne weiteren Verfahrensschritten in dem Herstellungsprozess unterzogen werden zu müssen, funktionell erfüllen könnte.

Ein weiterer Vorteil des erfindungsgemäßen Verfahrens ist, dass sich die Dicke der aufgebrachten Metallschicht an bestimmten Anforderungen im Rahmen desselben Verfahrensschrittes wunschgemäß anpassen lässt. D.h. mit dem erfindungsgemäßen Verfahren wird eine hohe Flexibilität hinsichtlich der Ausgestaltung der aufgebrachten Metallschicht erreicht, ohne dass zusätzliche Verfahrensschritte erforderlich sind.

Nach einer Ausführungsform des erfindungsgemäßen Verfahrens kann vor dem Aufbringen der Metallschicht zusätzlich eine elektrisch leitfähige Hilfsschicht zumindest oberhalb der monolithisch integrierten Spule des mikroelektronischen Schaltkreises aufgebracht werden, so dass die Metallschicht anschließend auf der Hilfsschicht aufgebracht wird.

Je nach Dicke, Ausgestaltung und Beschaffenheit der elektrisch leitfähigen Hilfsschicht kann diese unterschiedlichen Zwecken dienen.

Die elektrisch leitfähige Hilfsschicht kann beispielsweise bei einer schlechten Haftung zwischen der Metallschicht und der monolithisch integrierten Spule und/oder einer schlechten Haftung zwischen der Metallschicht und anderen Bereichen der Passivierungsschicht des mikroelektronischen Schaltkreises, die nicht entfernt worden sind, zur Verbesserung dieser Haftung verwendet werden. So wird gewährleistet, dass die Metallschicht festhaftend auf der Oberfläche zumindest der monolithisch integrierten Spule des mikroelektronischen Schaltkreises liegt.

Der Hilfsschicht kann aber auch eine Diffusionssperrfunktion innewohnen, wodurch gewährleistet wird, dass Metallatome der darauf angebrachten Metallschicht nicht in die nicht entfernten Bereiche der Passivierungsschicht hinein diffundieren und diese dadurch verunreinigen. Diese Barrierefunktion der Hilfsschicht ist zum Beispiel in dem Fall von großer Bedeutung, wenn als Metall für die Metallschicht Kupfer verwendet wird. Kupfer-Atome haben nämlich die Tendenz, über längere Zeit in Siliziumdioxid, das ein für Passivierungsschichten häufig verwendetes Material ist, zu diffundieren. Durch Ausnutzung der Diffusionssperrfunktion der Hilfsschicht kann ein solches Diffundieren der Kupferatome in die Passivierungsschicht hinein im Wesentlichen verhindert werden.

Die Hilfsschicht kann
- auf die monolithisch integrierte Spule des mikroelektronischen Schaltkreises, oder
- auf die monolithisch integrierte Spule des mikroelektronischen Schaltkreises und auf eventuell nicht entfernte Bereiche der Passivierungsschicht aufgebracht werden.

Beispielgebend für die Flexibilität des erfindungsgemäßen Verfahrens können Bereiche der Metallschicht und/oder der Hilfsschicht unabhängig voneinander oder zusammen mittels eines Nass- oder Trockenätzverfahrens entfernt werden. Beispielsweise kann nach dem Entfernen des mindestens einen Teils der Passivierungsschicht oberhalb der monolithisch integrierten Spule eine Metallschicht ganzflächig auf dem mikroelektronischen Schaltkreis aufgebracht werden, und diese Metallschicht kann sodann mittels eines Nass- oder Trockenätzverfahrens stellenweise weggeätzt werden derart, dass sich die gewünschte Strukturierung zumindest oberhalb der darunter liegenden monolithisch integrierten Spule ergibt. In diesem Fall wird keine Hilfsschicht verwendet.

Für den Fall, dass eine Hilfsschicht verwendet wird, kann diese nach dem Entfernen des mindestens einen Teils der Passivierungsschicht oberhalb der monolithisch integrierten Spule ganzflächig auf der Oberfläche des mikroelektronischen Schaltkreises aufgebracht werden. Von diesem Fertigungsstand aus hat man dann insbesondere zwei Möglichkeiten im Rahmen der Weiterverarbeitung.

Als erste Möglichkeit kann die Metallschicht auf der Hilfsschicht ganzflächig aufgebracht werden, und die Metallschicht und die darunterliegende Hilfsschicht können zusammen, d.h. in einem einzigen Verfahrensschritt mittels eines Nass- oder Trockenätzverfahrens derart entfernt werden, dass sich die gewünschte Strukturierung der nunmehr verdickten, monolithisch integrierten Spule ergibt.

Als zweite Möglichkeit kann nach dem Aufbringen der Hilfsschicht diese unter Bildung einer gewünschten Strukturierung stellenweise weggeätzt werden, und die Metallschicht kann sodann auf der bereits strukturierten Hilfsschicht aufgebracht werden. Im Anschluss daran erfolgt das stellenweise Entfernen der Metallschicht durch ein zweites Ätzverfahren derart, dass sich die gewünschte Struktur der Metallschicht ergibt. Zum Beispiel kann die Metallschicht derart weggeätzt werden, dass sie nur noch oberhalb derjeniger Stellen der monolithisch integrierten Spule liegt, die bereits mit einem Abschnitt der Hilfsschicht bedeckt sind.

Es ist aber auch durchaus möglich, dass eine solche Staffelung der Ätzverfahren, d.h. durch ein Nacheinanderschalten des Entfernens der Hilfsschicht und der Metallschicht, alle möglichen Schichtkombinationen hinsichtlich der Beschaffenheit und der relativen Lagen der Schichten zueinander der für die Leitfähigkeit maßgebliche Metallschicht möglich sind.

So kann durch ein solches Nacheinanderschalten der Ätzverfahren für die Hilfs- und die Metallschicht erreicht werden, dass ein einzelner mikroelektronischer Schaltkreis gebildet wird, so dass die Metallschicht beispielsweise:
- direkt auf der monolithisch integrierten Spule des mikroelektronischen Schaltkreises liegt;
- auf zumindest einem Bereich der Hilfsschicht liegt, der für sich direkt oberhalb einer monolithisch integrierten Spule des mikroelektronischen Schaltkreises liegt;
- direkt auf den nicht entfernten Bereichen der Passivierungsschicht liegt; oder
- auf zumindest einem Bereich der Hilfsschicht liegt, der für sich direkt auf den nicht entfernten Bereichen der Passivierungsschicht liegt.

Die obenstehenden Möglichkeiten zeigen die Flexibilität des erfindungsgemäßen Verfahrens zum Herstellen eines mikroelektronischen Schaltkreises mit zumindest einer monolithisch integrierten Spule, bei dem dessen Güte durch eine Verminderung der der monolithisch integrierten Spule innewohnenden Impedanz verbessert wird.

Es ist anzumerken, dass auch die zu Beginn des Verfahrens durchgeführte Entfernung von Bereichen der Passivierungsschicht mittels eines Nass- oder Trockenätzverfahrens erfolgen kann. Des weiteren ist die gezielte Entfernung bestimmter Bereiche der Passivierungsschicht, der Metallschicht und/oder der Hilfsschicht wie obenstehend erläutert mit Hilfe bekannter, photolithographischer Verfahren möglich.

Die Metallschicht und die Hilfsschicht können mittels eines Galvanisierverfahrens, eines stromlosen Abscheideverfahrens, eines Aufdampfverfahrens, eines Sputter-Verfahrens, eines Galvanisierverfahrens oder eines Plasma-CVD-Verfahrens (CVD = Chemical Vapor Deposition) aufgebracht werden.

Erfindungsgemäß wird die Metallschicht in einer Dicke von 0,5 µm bis 10 µm, vorzugsweise in einer Dicke von 3 µm bis 6 µm gebildet. Die Metallschicht kann aus einem Metall gebildet werden, welches dem Metall der monolithisch integrierten Spule entspricht, oder das von dem Metall der monolithisch integrierten Spule verschieden ist. Erfindungsgemäß wird bei dem Bilden der Metallschicht ein Metall hoher Leitfähigkeit, z.B. ein Metall, dessen Leitfähigkeit diejenige des Materials der monolithisch integrierten Spule übersteigt, verwendet. Beispiele solcher Metalle, die bei dem erfindungsgemäßen Verfahren verwendet werden können, sind Kupfer, Gold, Silber, Platin, Aluminium oder mehrere davon.

Unter dem Ausdruck "mehrere davon" ist sowohl die getrennte Verwendung mehrerer Metalle, so dass verschiedene Bereiche des mikroelektronischen Schaltkreises mit jeweils unterschiedlichen Metallen beschichtet werden, als auch die Verwendung mehrerer Metalle als eine homogene, den mikroelektronischen Schaltkreis ganzflächig beschichtende Legierung zu verstehen.

Es ist anzumerken, dass ein beliebiges Metall mit hoher Leitfähigkeit bei dem erfindungsgemäßen Verfahren verwendet werden kann.

Vorzugsweise wird die Hilfsschicht, falls vorhanden, in einer Dicke von 0,5 µm bis 20 µm gebildet, weiter vorzugsweise in einer Dicke von 5 µm bis 10 µm. Für die Bildung der Hilfsschicht können leitfähige Materialien verwendet werden, beispielsweise können Wolfram-Silizid, Titan, Platin, Nickel, Chrom, Nickel-Chrom Legierung, Molybdän, Palladium oder Rhodium verwendet werden.

Ausführungsbeispiele der Erfindung sind in den Figuren dargestellt und werden im Weiteren näher erläutert.

Es zeigen
- Figuren 1a bis 1d: in einer schematischen Schnittansicht einer fertig prozessierten, monolithisch integrierten Spule den Ablauf eines Ausführungsbeispiels des erfindungsgemäßen Verfahrens, bei dem eine Metallschicht direkt auf den Leiterbahnen der Spule aufgebracht wird;
- Figuren 2a bis 2d: in einer schematischen Schnittansicht einer fertig prozessierten, monolithisch integrierten Spule den Ablauf eines Ausführungsbeispiels des erfindungsgemäßen Verfahrens, bei dem eine Hilfsschicht und eine Metallschicht auf den Leiterbahnen der Spule aufgebracht werden, wobei die Hilfsschicht und die Metallschicht in demselben Verfahrensschritt weggeätzt werden;
- Figuren 3a bis 3d: in einer schematischen Schnittansicht einer fertig prozessierten, monolithisch integrierten Spule den Ablauf eines Ausführungsbeispiels des erfindungsgemäßen Verfahrens, bei dem eine Hilfsschicht und eine Metallschicht auf den Leiterbahnen der Spule aufgebracht werden, wobei die Hilfsschicht und die Metallschicht in voneinander getrennten Verfahrensschritten weggeätzt werden;
- Figuren 4a bis 4c: weitere, mögliche Ausführungsbeispiele des erfindungsgemäßen Verfahrens, bei dem die Metallschicht nicht nur oberhalb der Leiterbahnen der Spule liegt, sondern auch mit und ohne dazwischenliegender Hilfsschicht auf nicht entfernten Bereichen der Passivierungsschicht liegt; und
- Figuren 5a bis 6d: weitere, mögliche Ausführungsbeispiele.

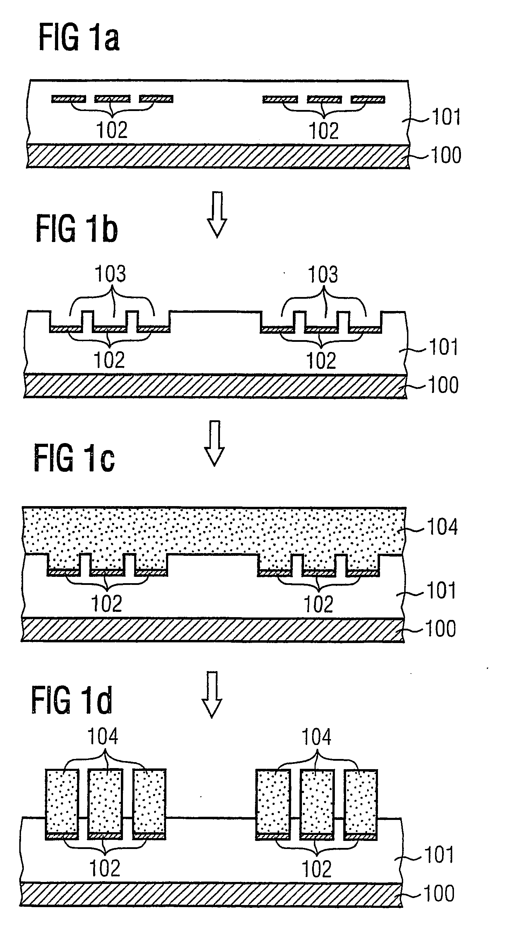

**Fig.1a** zeigt eine schematische Querschnittsansicht eines mikroelektronischen Schaltkreises, der ein Substrat 100, eine Passivierungsschicht 101 und Leiterbahnen 102 einer Spule aufweist. Bei dem in **Fig.1a** gezeigten, fertig prozessierten mikroelektronischen Schaltkreis, sind die Leiterbahnen 102 jeweils von einem Teil der Passivierungsschicht 101 bedeckt.

**Fig.1b** zeigt eine schematische Querschnittsansicht des mikroelektronischen Schaltkreises aus **Fig.1a****,** bei der die Bereiche der Passivierungsschicht 101 oberhalb der Leiterbahnen 102 entfernt worden sind, so dass entfernte Bereiche 103 oberhalb der jeweiligen Leiterbahnen der monolithisch integrierten Spule gebildet werden.

**Fig.1c** zeigt das Ergebnis eines ganzflächigen Aufbringens einer Metallschicht 104 auf der Oberfläche des mikroelektronischen Schaltkreises. Zweckdienlicherweise besitzt das Metall der Metallschicht 104 eine gegenüber der Leitfähigkeit des Metalls der Leiterbahnen 102 höhere intrinsische Leitfähigkeit. Diese Metallschicht 104 kontaktiert sowohl die Leiterbahnen 102 der Spule direkt als auch die nicht entfernten Bereiche der Passivierungsschicht 101. Des weiteren kontaktiert die Metallschicht 104 die durch das Entfernen der sich oberhalb der Leiterbahnen 102 der Spule befindlichen Bereiche der Passivierungsschicht 101 erzeugten Seitenwände der in **Fig.1b** gezeigten entfernten Bereiche 103.

**Fig.1d** zeigt das Ergebnis des Entfernens von bestimmten Bereichen der Metallschicht 104 aus **Fig.1c** derart, dass das Metall der Metallschicht 104 nur noch oberhalb der jeweiligen Leiterbahnen 102 der Spule in direktem elektrischem Kontakt mit diesen stehend zurückbleibt. So werden die Leiterbahnen 102 der Spule gegenüber ihrem Ausgangszustand verdickt, was eine Erhöhung der intrinsischen Leitfähigkeit der Leiterbahnen 102 bewirkt. Diese erhöhte Leitfähigkeit führt somit zu einer verbesserten Güte der Spule.

In einem weiteren Schritt (nicht gezeigt) werden die Oberfläche der Passivierungsschicht 101 sowie die nunmehr um die Metallschicht 104 verdickte Leiterbahnen 102 der Spule mit einer weiteren Passivierungsschicht zum Schutz gegen äußere Einwirkungen beschichtet.

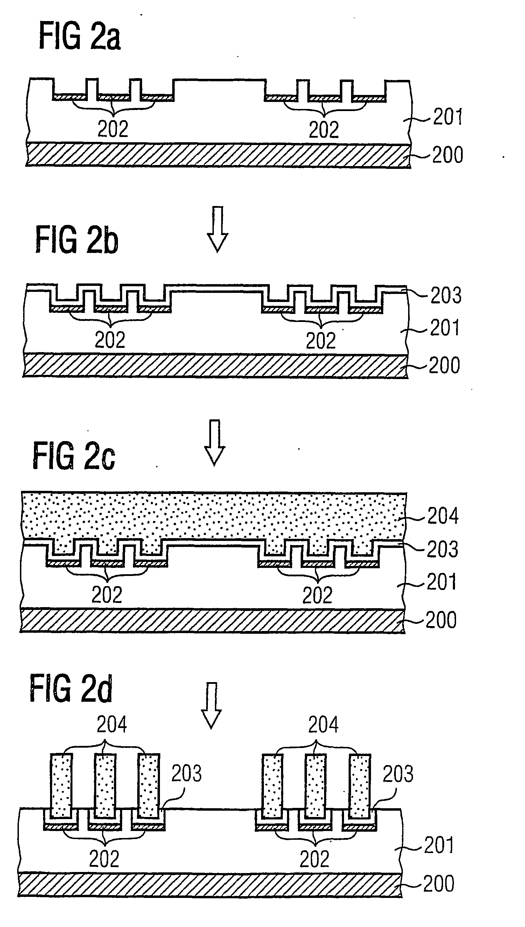

**Fig.2a** zeigt den mikroelektronischen Schaltkreis im Fertigungsstand der **Fig.1b****,** bei der die Bereiche der Passivierungsschicht 201 oberhalb der jeweiligen Leiterbahnen 202 der Spule entfernt worden sind.

**Fig.2b** zeigt das Ergebnis des Aufbringens einer Hilfsschicht 203 auf der gesamten Oberfläche des mikroelektronischen Schaltkreises. Dabei werden sämtliche Flächen der nicht entfernten Passivierungsschicht 201 sowie der Leiterbahnen 202 der Spule mit der Hilfsschicht 203 beschichtet. Des weiteren werden auch durch die Entfernung der sich oberhalb der Leiterbahnen 202 befindlichen Bereiche der Passivierungsschicht 201 freigelegten Flächen der Passivierungsschicht 201 seitlich zu den Leiterbahnen 202 der Spule mit der Hilfsschicht bedeckt.

Es ist anzumerken, dass die in **Fig.2c** abgebildete Darstellung eine Schnittansicht ist, d.h. die Leiterbahnen 202 erstrecken sich sowohl aus der Fläche des Papiers heraus als auch aus der hinteren Fläche des Papiers hinein, so dass die durch die Entfernung der Passivierungsschicht 201 freigelegten Bereiche langgestreckte, grabenförmige Aussparungen in der Oberfläche der Passivierungsschicht 201 sind. Aus diesem Grund nimmt auch die an diesen Aussparungen enganschmiegende Hilfsschicht 203 diese langgestreckte, grabenförmige Gestalt an.

**Fig.2c** zeigt das Ergebnis des Aufbringens einer Metallschicht 204 auf der Hilfsschicht 203.

**Fig.2d** zeigt das Ergebnis des Entfernens der Metallschicht 204 und der Hilfsschicht 203 derart, dass nur die sich oberhalb der Leiterbahnen 202 der Spule befindlichen Bereiche der Passivierungsschicht 201 der Hilfsschicht 203 und der Metallschicht 204 nach dem Entfernen zurückbleiben. Somit ist gemäß diesem Ausführungsbeispiel die Metallschicht 204 von den jeweiligen Leiterbahnen 202 der Spule durch die Hilfsschicht 203 getrennt. Da die Hilfsschicht 203 wie oben erläutert eine elektrische Leitfähigkeit aufweist, wird die elektrische Kontaktierung zwischen den jeweiligen Leiterbahnen 202 und der Metallschicht 204 gewährleistet.

Bei dem in **Fig.2** dargestellten Ausführungsbeispiel ist anzumerken, dass das Entfernen der Metallschicht 204 und der Hilfsschicht 203 in einem einzigen Schritt, z.B. durch Nass- oder Trockenätzen erfolgen kann.

In einem weiteren Schritt (nicht gezeigt) kann die Oberfläche der Passivierungsschicht 201 sowie die nunmehr um die Metallschicht 204 verdickten Leiterbahnen 202 der Spule mit einer weiteren Passivierungsschicht zum Schutz gegen äußere Einwirkungen beschichtet werden.

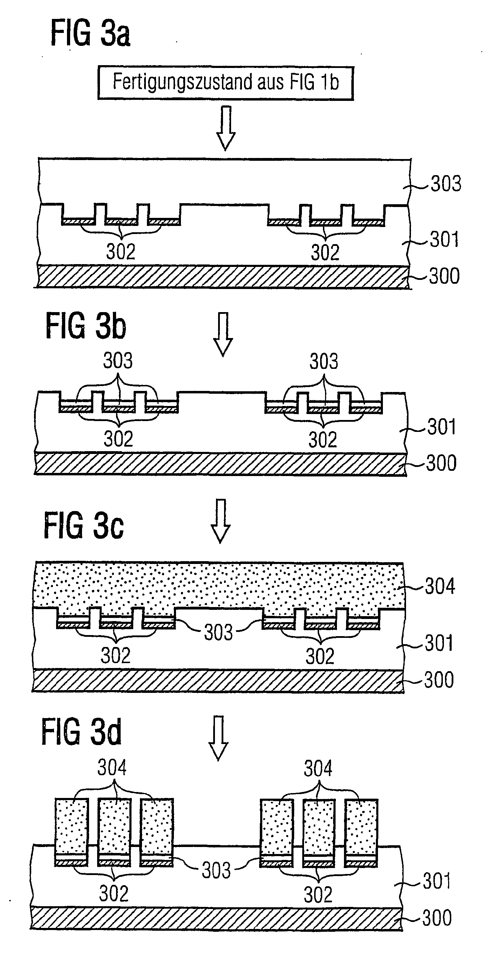

Ausgehend von **Fig.1b** zeigt **Fig.3a** das Ergebnis des Aufbringens einer Hilfsschicht 303 ganzflächig auf dem mikroelektronischen Schaltkreis. Hierbei werden sowohl die freigelegten Leiterbahnen 202 der Spule als auch die durch die anfangs erfolgte Entfernung der Teile der Passivierungsschicht 301 freigelegten Bereiche der Leiterbahnen 202 der Spule sowie diejenige Bereiche der Passivierungsschicht 301, die nicht entfernt worden sind, mit der Hilfsschicht 303 beschichtet.

**Fig.3b** zeigt den Fertigungszustand des mikroelektronischen Schaltkreises nach Entfernung der Hilfsschicht 303 derart, dass nur diejenige Bereiche der Hilfsschicht 303 zurückbleiben, die direkt oberhalb der jeweiligen Leiterbahnen 302 der Spule liegen. Die Hilfsschicht wird beispielsweise mittels eines Nass- oder Trockenätzverfahrens weggeätzt.

Sodann wird eine Metallschicht 304 ganzflächig auf dem mikroelektronischen Schaltkreis aufgebracht. Die Metallschicht 304 kontaktiert nur die obersten Flächen der Passivierungsschicht 301 sowie die direkt oberhalb der jeweiligen Leiterbahnen 302 der Spule liegenden Bereiche der Hilfsschicht 303.

**Fig.3d** zeigt das Ergebnis des Entfernens von Bereichen der Metallschicht 304 derart, dass die Metallschicht 304 nur noch oberhalb derjenigen Bereiche zurückbleibt, wo sich bereits ein Abschnitt der Hilfsschicht 303 befindet.

Es ist anzumerken, dass bei dem in **Fig.3** dargestellten Ausführungsbeispiel des Verfahrens das Entfernen von der Hilfsschicht 303 und der Metallschicht 304 in zwei voneinander getrennten Verfahrensschritten erfolgen.

In einem weiteren Schritt (nicht gezeigt) kann die freigelegte Oberfläche der Passivierungsschicht 301 sowie die nunmehr um die Metallschicht 304 verdickte Leiterbahnen 302 der Spule mit einer weiteren Passivierungsschicht zum Schutz gegen äußere Einwirkungen beschichtet werden.

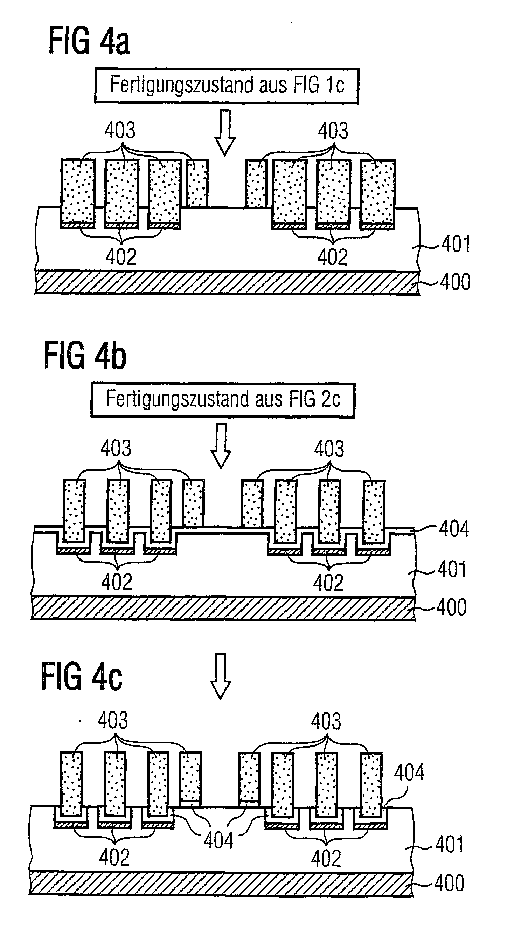

Das in **Fig.4a** gezeigte Ausführungsbeispiel geht zunächst von dem Fertigungszustand aus **Fig.1c** aus, bei dem eine Metallschicht 104 ohne Hilfsschicht ganzflächig auf der Oberfläche des mikroelektronischen Schaltkreises aufgebracht wurde. Von **Fig.1c** ausgehend wird dann die Metallschicht 104 entfernt derart, dass Bereiche sowohl direkt oberhalb der jeweiligen Leiterbahnen der Spule 402 als auch direkt oberhalb der nicht entfernten Bereiche der Passivierungsschicht 401 zurückbleiben. Somit können z.B. jedwede übrigen Bereiche der Fläche der Passivierungsschicht 401 zur Weiterbildung der bereits bestehenden Spule ausgenutzt werden.

In einem weiteren Schritt (nicht gezeigt) können die entfernten Bereiche der Passivierungsschicht 401 sowie die nunmehr um die Metallschicht 403 verdickten Leiterbahnen 402 der Spule mit einer weiteren Passivierungsschicht zum Schutz gegen äußere Einwirkungen beschichtet werden.

**Fig.4b** geht von dem Fertigungsstand aus **Fig.2c** aus, bei dem sowohl eine Hilfsschicht 203 als auch eine Metallschicht 204 nacheinanderfolgend auf der Oberfläche des mikroelektronischen Schaltkreises aufgebracht wurden. **Fig.4b** zeigt das Ergebnis des Entfernens sowohl derjeniger Bereiche der Metallschicht 403 (entspricht der Metallschicht 104 in **Fig.2c****),** die direkt oberhalb der jeweiligen Leiterbahnen 402 der Spule liegen, als auch andere Bereiche der Metallschicht 403, die auf der Hilfsschicht oberhalb des nicht entfernten Bereichs der Passivierungsschicht 401 liegen.

**Fig.4c** zeigt das Endergebnis nach dem Entfernen derjeniger Bereiche der Hilfsschicht 404, auf denen keine Metallschicht 403 liegt.

Es ist anzumerken, dass das Entfernen der Metallschicht 403 und das Entfernen der Hilfsschicht 404 in zwei voneinander getrennten Verfahrensschritte oder als einen einzigen Verfahrensschritt erfolgen können.

In einem weiteren Schritt (nicht gezeigt) können die entfernten Bereiche der Passivierungsschicht 401 sowie die nunmehr um die Metallschicht 403 verdickten Leiterbahnen 402 der Spule mit einer weiteren Passivierungsschicht zum Schutz gegen äußere Einwirkungen beschichtet werden.

Die in **Fig.4** gezeigten Ausführungsbeispiele der Erfindung sind als beispielgebend zu verstehen dahin, dass durch Trennen der Entfernungsschritte der Metallschicht und der Hilfsschicht zahlreiche verschiedene Ausgestaltungen der Spule und im Allgemeinen des mikroelektronischen Schaltkreises hinsichtlich der relativen Anordnungen der Metall- und Hilfsschichten möglich sind.

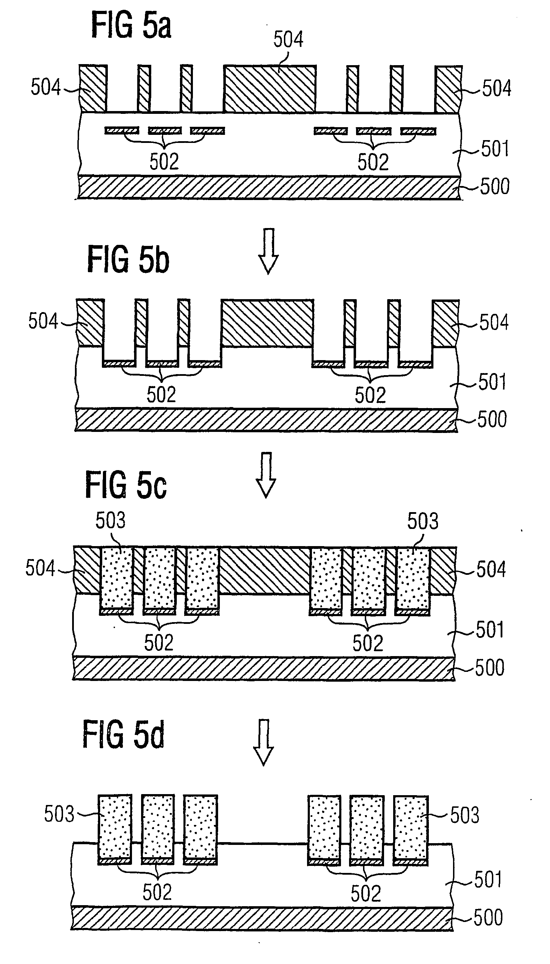

**Fig.5** zeigt ein weiteres Ausführungsbeispiel der Erfindung, in dem ein Substrat 500, eine Passivierungsschicht 501, Leiterbahne 502 einer Spule in Schnittansicht, eine Metallschicht 503 und eine Schicht Fotolack 504 zu sehen sind. In **Fig.5a** wird auf die Passivierungsschicht 501 zunächst eine Schicht Fotolack 504 aufgebracht, und diese wird fotolithographisch oberhalb der Stellen der Passivierungsschicht 501 geätzt, die sich ihrerseits oberhalb der Leiterbahne 502 der Spule befinden.

**Fig.5b** zeigt das Ergebnis nach dem Ätzen der Bereiche der Passivierungsschicht 501, die sich oberhalb der Leiterbahne 502 befinden.

In **Fig.5c** wird der mikroelektronische Schaltkreis dann einem Galvanisierverfahren unterzogen, so dass das die Metallschicht 503 sozusagen "automatisch" auf den Leiterbahnen aufwächst. So wird erreicht, dass die Schicht Fotolack 504 als eine Maske funktioniert, die die örtliche Spezifität des Metallwachstums bestimmt.

Die Schicht Fotolack 503 kann dann sodann anschließend entfernt werden, so dass man das in **Fig.5d** gezeigte Ergebnis erhält. Dieses Endergebnis entspricht demjenigen aus **Fig.1d****.**

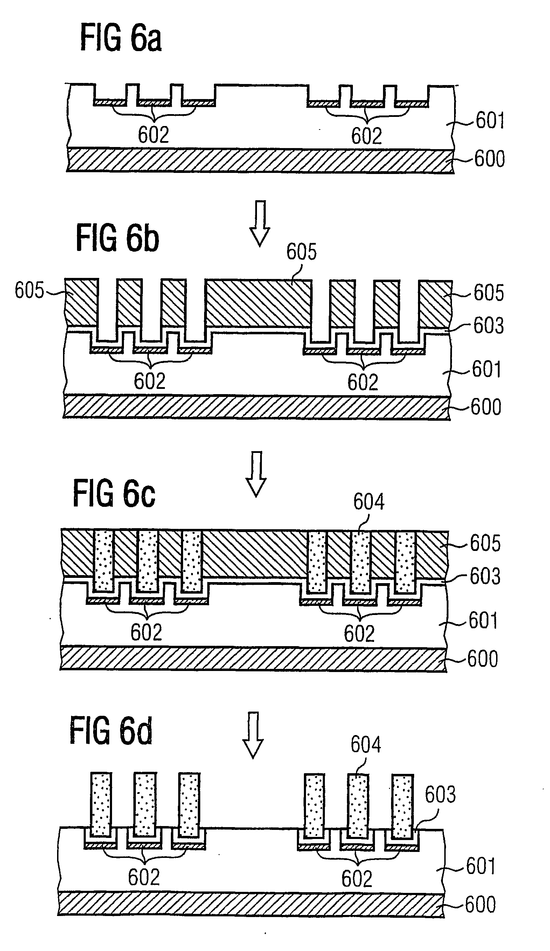

**Fig.6** zeigt ein weiteres Ausführungsbeispiel der Erfindung, in dem ein Substrat 600, eine Passivierungsschicht 601, Leiterbahne 602 einer Spule in Schnittansicht, eine elektrisch leitfähige Hilfsschicht 603, eine Metallschicht 604 und eine Schicht Fotolack 605 zu sehen sind. Fig.6a entspricht dem Fertigungsstand der Fig.1b, in dem diejenige Bereiche der Passivierungsschicht 601, die sich oberhalb der Leiterbahne 602 der Spule befinden, bereits weggeätzt worden sind.

In **Fig.6b** wird auf die Passivierungsschicht 601 zunächst eine Schicht Fotolack 605 aufgebracht, und diese wird fotolithographisch oberhalb der Stellen einer elektrisch leitfähigen Hilfsschicht 601 geätzt, die sich ihrerseits oberhalb der Leiterbahne 602 der Spule befinden.

In **Fig.6c** wird der mikroelektronische Schaltkreis dann einem Galvanisierverfahren unterzogen, so dass das die Metallschicht 604 sozusagen "automatisch" auf den Leiterbahnen aufwächst. So wird erreicht, dass die Schicht Fotolack 605 als eine Maske funktioniert, die die örtliche Spezifität des Metallwachstums bestimmt.

Die Schicht Fotolack 605 kann dann sodann anschließend entfernt werden, so dass man das in **Fig.6d** gezeigte Ergebnis erhält. Dieses Endergebnis entspricht demjenigen aus **Fig.2d****.**

In diesem Dokument sind folgende Veröffentlichungen zitiert:
[1] EP 551735
[2] US 4 613 843
[3] DE 197 21 310 A1
[4] DE 197 37 294 A1
[5] WO 95/05678
[6] US 5 652 173
[7] US 5 793 272

## Patentansprüche

1. Verfahren zum Herstellen eines mikroelektronischen Schaltkreises mit mindestens einer monolithisch integrierten Spule,
• bei dem ein funktionsfähiger, fertig prozessierter mikroelektronischer Schaltkreis mit einer monolithisch integrierten Spule und mit einer oberhalb zumindest der monolithisch integrierten Spule befindlichen Passivierungsschicht bereitgestellt wird;
• bei dem ein Teil der Passivierungsschicht oberhalb der monolithisch integrierten Spule entfernt wird, so dass ein Bereich der Spule freigelegt wird; und
• bei dem oberhalb der monolithisch integrierten Spule eine Metallschicht aufgebracht wird derart, dass die Metallschicht mit der monolithisch integrierten Spule elektrisch leitend gekoppelt wird, womit eine verdickte Leiterbahn der monolithisch integrierten Spule gebildet wird, womit die Güte der monolithisch integrierten Spule erhöht wird.

2. Verfahren gemäß Anspruch 1,
• bei dem zumindest oberhalb der monolithisch integrierten Spule eine elektrisch leitfähige Hilfsschicht aufgebracht wird, und
• bei dem auf der Hilfsschicht die Metallschicht aufgebracht wird.

3. Verfahren gemäß Anspruch 2,
bei dem Bereiche der Hilfsschicht vor dem Aufbringen der Metallschicht entfernt werden derart, dass sich die Hilfsschicht nach dem Entfernen
• oberhalb der monolithisch integrierten Spule oder
• oberhalb der monolithisch integrierten Spule und oberhalb eines nicht entfernten Bereichs der Passivierungsschicht
befindet.

4. Verfahren gemäß Anspruch 1,
bei dem Bereiche der Metallschicht entfernt werden derart, dass die Metallschicht direkt oberhalb der monolithisch integrierten Spule liegt.

5. Verfahren gemäß einem der Ansprüche 2 oder 3, bei dem Bereiche der Metallschicht entfernt werden derart, dass die Metallschicht direkt oberhalb der Hilfsschicht liegt.

6. Verfahren gemäß einem der Ansprüche 1 bis 5,
bei dem die Entfernung
• der Passivierungsschicht und/oder
• der Metallschicht
mittels eines Nass- oder Trockenätzverfahrens durchgeführt wird.

7. Verfahren gemäß einem der Ansprüche 2, 3 oder 5,
bei dem die Hilfsschicht mittels eines Nass- oder Trockenätzverfahrens entfernt wird.

8. Verfahren gemäß einem der Ansprüche 1 bis 7,
bei dem die Metallschicht mittels
• eines Galvanisierverfahrens,
• eines stromlosen Abscheideverfahrens,
• eines Sputterverfahrens,
• eines Aufdampfverfahrens, oder
• eines Plasma-CVD-Verfahrens
aufgebracht wird.

9. Verfahren gemäß einem von den Ansprüchen 2 oder 3 abhängigen Anspruch, bei dem die Hilfsschicht mittels eines der im Anspruch 8 aufgeführten Verfahren aufgebracht wird.

10. Verfahren nach einem der Ansprüche 1 bis 9,
bei dem die Metallschicht in einer Dicke von 0,5 µm bis 10 µm gebildet wird.

11. Verfahren gemäß Anspruch 10,
bei dem die Metallschicht in einer Dicke von 3 µm bis 6 µm gebildet wird.

12. Verfahren gemäß einem der Ansprüche 1 bis 11,
bei dem die Metallschicht aus einem Metall gebildet wird, welches dem Metall der monolithisch integrierten Spule entspricht, oder das von dem Metall der monolithisch integrierten Spule verschieden ist.

13. Verfahren gemäß einem der Ansprüche 1 bis 12,
bei dem die Metallschicht aus
• Cu,
• Au,
• Ag,
• Pt,
• Al, oder
• mehreren davon
gebildet wird.

14. Verfahren gemäß einem von den Ansprüchen 2 oder 3 abhängigen Anspruch, bei dem als Material für die Hilfsschicht
• WSi,
• Ti,
• Pt,
• NiCr,
• Mo,
• Pd, oder
• Rh
verwendet wird.

15. Verfahren gemäß einem von den Ansprüchen 2 oder 3 abhängigen Anspruch, bei dem die Hilfsschicht in einer Dicke von 0,5 µm bis 20 µm gebildet wird.

## Claims

1. Method for fabricating a microelectronic circuit having at least one monolithically integrated coil,
• in which provision is made of a functioning readily processed microelectronic circuit having a monolithically integrated coil and a passivation layer situated above at least the monolithically integrated coil;
• in which a part of the passivation layer above the monolithically integrated coil is removed so that a region of the coil is exposed; and
• in which a metal layer is applied above the monolithically integrated coil in such a way that the metal layer is electrically conducting coupled with the monolithically integrated coil thereby forming a thickened conducting path of the monolithically integrated coil thereby increasing the quality factor of the monolithically integrated coil.

2. Method according to claim 1,
• in which an electrically conducting auxiliary layer is applied at least above the monolithically integrated coil, and
• in which the metal layer is applied on the auxiliary layer.

3. Method according to claim 2,
in which regions of the auxiliary layer are removed before the application of the metal layer in such a way that, after the removal, the auxiliary layer is situated
• above the monolithically integrated coil or
• above the monolithically integrated coil and above an unremoved region of the passivation layer.

4. Method according to claim 1,
• in which regions of the metal layer are removed in such a way that the metal layer lies directly above the monolithically integrated coil.

5. Method according to one of claims 2 or 3,
in which regions of the metal layer are removed in such a way that the metal layer lies directly above the auxiliary layer.

6. Method according to one of claims 1 to 5, in which the removal of
• the passivation layer and/or
• the metal layer
is carried out by means of a wet etching method or a dry etching method.

7. Method according to one of claims 2, 3 or 5,
in which the auxiliary layer is removed by means of a wet etching method or a dry etching method.

8. Method according to one of claims 1 to 7,
in which the metal layer is applied by means of
• an electro deposition method,
• an electroless deposition method,
• a sputtering method,
• a vapour deposition method, or
• a plasma CVD method.

9. Method according to one of the claims depending on claim 2 or 3,
in which the auxiliary layer is applied by means of one of the methods listed in claim 8.

10. Method according to one of claims 1 to 9,
in which the metal layer is formed with a thickness of 0.5 µm to 10 µm.

11. Method according to claim 10,
in which the metal layer is formed with a thickness of 3 µm to 6 µm.

12. Method according to one of claims 1 to 11,
in which the metal layer is formed from a metal which corresponds to the metal of the monolithically integrated coil, or which is different from the metal of the monolithically integrated coil.

13. Method according to one of claims 1 to 12,
in which the metal layer is formed from
• Cu,
• Au,
• Ag,
• Pt,
• Al, or
• a plurality thereof.

14. Method according to one of the claims depending on claim 2 or 3,
in which the material used for the auxiliary layer is
• WSi,
• Ti,
• Pt,
• NiCr,
• Mo,
• Pd, or
• Rh.

15. Method according to one of the claims depending on claim 2 or 3, in which the auxiliary layer is formed with a thickness of 0.5 µm to 20 µm.

## Revendications

1. Procédé de fabrication d'un circuit microélectronique ayant au moins une bobine intégrée monolithiquement,
• dans lequel on prépare un circuit microélectronique apte à fonctionner, fini de traitement, intégré monolithiquement et ayant une couche de passivation se trouvant au-dessus d'au moins la bobine intégrée monolithiquement ;
• dans lequel on élimine une partie de la couche de passivation au-dessus de la bobine intégrée monolithiquement de manière à mettre à nu une partie de la bobine ; et
• dans lequel on dépose au-dessus de la bobine intégrée monolithiquement une couche métallique de façon à ce que la couche métallique soit accouplée d'une manière conductrice de l'électricité avec la bobine intégrée monolithiquement en formant ainsi une piste conductrice épaissie de la bobine intégrée monolithiquement, ce qui augmente la qualité de la bobine intégrée monolithiquement.

2. Procédé suivant la revendication 1,
• dans lequel on dépose une couche auxiliaire conductrice de l'électricité au moins au-dessus de la bobine intégrée monolithiquement, et
• dans lequel on dépose la couche métallique sur la couche auxiliaire.

3. Procédé suivant la revendication 2,
dans lequel on élimine les parties de la couche auxiliaire avant le dépôt de la couche métallique de façon à ce que la couche auxiliaire après l'élimination se trouve
• au-dessus de la bobine intégrée monolithiquement ou
• au-dessus de la bobine intégrée monolithiquement et au-dessus d'une partie non éliminée de la couche de passivation.

4. Procédé suivant la revendication 1,
dans lequel on élimine des parties de la couche métallique de façon à ce que la couche métallique se trouve directement au-dessus de la bobine intégrée monolithiquement.

5. Procédé suivant l'une des revendications 2 ou 3,
dans lequel on élimine des parties de la surface métallique de façon à ce que la couche métallique se trouve directement au-dessus de la couche auxiliaire.

6. Procédé suivant l'une des revendications 1 à 5,
dans lequel on effectue l'élimination
• de la couche de passivation et/ou
• de la couche de métal
au moyen d'un procédé d'attaque en voie humide ou en voie sèche.

7. Procédé suivant l'une des revendications 2, 3 ou 5,
dans lequel on élimine la couche auxiliaire au moyen d'un procédé d'attaque en en voie humide ou en voie sèche.

8. Procédé suivant l'une des revendications 1 à 7,
dans lequel on dépose la couche de métal au moyen
• d'un procédé de galvanisation,
• d'un procédé de dépôt sans courant électrique,
• d'un procédé de pulvérisation cathodique,
• d'un procédé de dépôt en phase vapeur, ou
• d'un procédé CVD au plasma.

9. Procédé suivant l'une des revendications dépendantes des revendications 2 ou 3,
dans lesquelles on dépose la couche auxiliaire au moyen de l'un des procédés mentionnés dans la revendication 8.

10. Procédé suivant l'une des revendications 1 à 9,
dans lequel on forme la couche de métal en une épaisseur de 0,5 µm à 10 µm.

11. Procédé suivant la revendication 10,
dans lequel on forme la couche de métal en une épaisseur de 3 µm à 6 µm.

12. Procédé suivant l'une des revendications 1 à 11,
dans lequel on forme la couche de métal en un métal qui correspond au métal de la bobine intégrée monolithiquement ou qui est différent du métal de la couche intégrée monolithiquement.

13. Procédé suivant l'une des revendications 1 à 12, dans lequel la couche de métal est en
• Cu,
• Au,
• Ag,
• Pt,
• Al, ou
• plusieurs de ceux-ci.

14. Procédé suivant l'une des revendications dépendantes de la revendication 2 ou 3,
dans lequel on utilise comme matériau pour la couche auxiliaire
• WSi,
• Ti,
• Pt,
• NiCr,
• Mo,
• Pd ou
• Rh

15. Procédé suivant l'une des revendications dépendantes des revendications 2 ou 3,
dans lequel on forme la couche auxiliaire en une épaisseur de 0,5 µm à 20 µm.
